# EUROPÄISCHE PATENTANMELDUNG

(11) **EP 4 253 984 A1**
(43) Veröffentlichungstag der Anmeldung: **04.10.2023**
(21) Anmeldenummer: 22165383.5
(22) Anmeldetag: 30.03.2022
(51) Int. Cl.: G01R 33/485, G01R 33/48, G01R 33/56

(54) **VERFAHREN ZUR MAGNETRESONANZ-BILDGEBUNG, COMPUTERPROGRAMM, SPEICHERMEDIUM UND MAGNETRESONANZGERÄT**

(71) Anmelder: Siemens Healthcare GmbH, 91052 Erlangen (DE)
(72) Erfinder: Zeller, Mario, 91054 Erlangen (DE); Paul, Dominik, 91088 Bubenreuth (DE)

(57) **Zusammenfassung**

Die Erfindung betrifft ein Verfahren zur Aufnahme von Magnetresonanz-Messdaten eines Untersuchungsobjekts in einem Untersuchungsbereich mittels eines Magnetresonanzgeräts (15), umfassend die folgenden Verfahrensschritte:
- Messen (S1) einer BO-Feldkarte (1) des Untersuchungsbereichs basierend auf der Anwendung einer Pre-Pulssequenz,
- Bereitstellen (S2) einer Fett-Maske für den Untersuchungsbereich,
- Ermitteln (S3) einer Fett-BO-Feldkarte und einer Wasser-BO-Feldkarte basierend auf der gemessenen BO-Feldkarte (1) und der Fett-Maske,
- Ermitteln (S4) von mehreren Konfigurationsparametersätzen für das Magnetresonanzgerät (15), wobei ein Fett-Konfigurationsparametersatz basierend auf der Fett-BO-Feldkarte und ein Wasser-Konfigurationsparametersatz basierend auf der Wasser-BO-Feldkarte ermittelt werden, wobei der Fett-Konfigurationsparametersatz einen für Fett optimierten Konfigurationsparametersatz bildet und der Wasser-Konfigurationsparametersatz einen für Wasser optimierten Konfigurationsparametersatz bildet,
- Erstellen (S5) einer Mess-Pulssequenz basierend auf Fett-Konfigurationsparametersatz und dem Wasser-Konfigurationsparametersatz,
- Erfassen (S6) von Magnetresonanz-Messdaten des Untersuchungsbereichs des Untersuchungsobjekts basierend auf der Anwendung der Mess-Pulssequenz.

## Beschreibung

Die Erfindung betrifft ein verbessertes Verfahren zur Magnetresonanz-Bildgebung, das eine Erfassung von Magnetresonanz-Messdaten eines Untersuchungsbereichs basierend auf der Anwendung einer Mess-Pulssequenz umfasst.

Die Magnetresonanzbildgebung und ihre Grundlagen sind im Stand der Technik bereits weitgehend bekannt. Ein zu untersuchendes Objekt wird in ein Grundmagnetfeld mit einer relativ hohen Feldstärke, das sogenannte BO-Feld, eingebracht. Für das zu untersuchende Objekt können Magnetresonanz-Messdaten für einzelne Schichten aufgenommen werden oder für ein Volumen aufgenommen werden, beispielsweise als ein Stack von mehreren Schichten. Um die Magnetresonanz-Messdaten aufnehmen zu können, werden die Spins dieser Schicht angeregt und es wird beispielsweise der Zerfall dieser Anregung als Signal betrachtet. Mittels einer Gradientenspulenanordnung können Gradientenfelder erzeugt werden, während über eine Hochfrequenzspulenanordnung hochfrequente Anregungspulse ausgesendet werden, die häufig als Hochfrequenzpulse bezeichnet werden. Durch die Gesamtheit der Hochfrequenzpulse ("Anregung") wird ein Hochfrequenzfeld erzeugt, das üblicherweise als B1-Feld bezeichnet wird und die Spins resonant angeregter Kerne, durch die Gradienten ortsaufgelöst, um einen sogenannten Flipwinkel gegenüber den Magnetfeldlinien des Grundmagnetfelds verkippt. Die angeregten Spins der Kerne strahlen dann Hochfrequenzsignale ab, die mittels geeigneter Empfangsantennen, insbesondere auch der Hochfrequenzspulenanordnung selbst, als die Magnetresonanz-Messdaten aufgenommen und weiterverarbeitet werden können, um so Magnetresonanz-Bilddaten rekonstruieren zu können. Die Aufnahme der Magnetresonanz-Messdaten erfolgt insbesondere durch Anwenden einer Mess-Pulssequenz, welche einen zeitlichen Ablaufplan des Aussendens von Anregungspulsen und/oder Magnetisierungen beschreibt. Mit anderen Worten beschreibt die auszusendende Mess-Pulssequenz eine Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen. Zeitlich passend zur Mess-Pulssequenz werden Auslesefenster gesetzt, welche die Zeiträume vorgeben, in denen die induzierten Magnetresonanz-Signale bzw. Hochfrequenzsignale aufgenommen werden.

Bei der Magnetresonanz-Bildgebung mittels eines Magnetresonanzgeräts ist die Homogenität eines Hauptmagnetfelds in einem Untersuchungsvolumen von großer Bedeutung. Bereits bei kleinen Abweichungen der Homogenität kann es zu großen Abweichungen in einer Frequenzverteilung der Kernspins kommen, so dass qualitativ minderwertige Magnetresonanz-Messdaten aufgenommen werden. Die effektive Inhomogenität des BO-Feldes ist zum einen durch technische Imperfektionen bedingt, zum anderen aber auch durch von dem Untersuchungsobjekt, insbesondere einem Patienten, induzierte und individuell verschiedene Suszeptibilitätseffekte.

Um den Inhomogenitäten des Hauptmagnetfelds entgegenzuwirken, umfassen Magnetresonanzgeräte häufig eine justierbare Shimeinheit. Mittels der Shimeinheit kann individuell für verschiedene Untersuchungsobjekte ein Shimvorgang (in vivo shimming) durchgeführt werden. Bei diesem Shimvorgang wird üblicherweise zunächst ein lokales BO-Feld in einem Untersuchungsbereich gemessen, wobei eine BO-Feldkarte, auch BO-map genannt, erstellt wird. Anhand der BO-Feldkarte können konstante Shimströme (DC-Offset Ströme), welche durch Gradientenspulen des Magnetresonanzgeräts fließen, ermittelt werden. Weiterhin können anhand der BO-Feldkarte Ströme für spezielle Shimkanäle höherer Ordnung berechnet werden, die lokale Feldverzerrungen besonders vorteilhaft kompensieren können. Nach Einstellung dieser Ströme wird in der Regel in einer Frequenzjustage eine Resonanzfrequenz für gewünschte spektrale Komponenten eines untersuchten Gewebes, insbesondere von gebundenen Protonen, ermittelt werden. Die DC-Offset Shimströme durch die Gradientenspulen und/oder die Ströme für die Shimkanäle höherer Ordnung und/oder die Resonanzfrequenz können einen Konfigurationsparametersatz bilden oder Teil eines Konfigurationsparametersatzes sein, wobei der Konfigurationsparametersatz für das Erfassen von Magnetresonanz-Messdaten eingesetzt werden kann.

Es ist bekannt, dass eine Kompensation von lokalen Feldverzerrungen umso vollständiger funktioniert, je kleiner ein Volumen ist, in dem das Hauptmagnetfeld BO homogenisiert werden soll. Es kann deshalb Sinn machen, verschiedene Shimparametersätze bzw. Konfigurationsparametersätze für mehrere Teilbereiche des Untersuchungsbereichs separat zu ermitteln und die Shimeinheit anhand der verschiedenen Shimparametersätze für das Erfassen von Magnetresonanz-Messdaten aus den mehreren Teilbereichen unterschiedlich einzustellen.

Der Erfindung liegt die Aufgabe zugrunde, eine verbesserte Aufnahme von Magnetresonanz-Messdaten eines Untersuchungsobjekts bereitzustellen, welche die Rekonstruktion von qualitativ hochwertigeren Magnetresonanz-Bilddaten aus den Magnetresonanz-Messdaten erlaubt, wobei die Magnetresonanz-Messdaten unter Einsatz von Fett- und Wasser-Konfigurationsparametersätzen erfasst werden. Die Aufgabe wird durch die Merkmale der unabhängigen Ansprüche gelöst. Vorteilhafte und/oder bevorzugte Ausgestaltungen sind in den Unteransprüchen, der Beschreibung und den beigefügten Figuren beschrieben.

Das erfindungsgemäße Verfahren zur Magnetresonanz-Bildgebung eines Untersuchungsobjekts in einem Untersuchungsbereich mittels eines Magnetresonanzgeräts umfasst die folgenden Verfahrensschritte:
- Messen einer BO-Feldkarte des Untersuchungsbereichs basierend auf der Anwendung einer Pre-Pulssequenz,
- Bereitstellen einer Fett-Maske für den Untersuchungsbereich,
- Ermitteln einer Fett-BO-Feldkarte und einer Wasser-BO-Feldkarte basierend auf der gemessenen BO-Feldkarte und der Fett-Maske,
- Ermitteln von mehreren Konfigurationsparametersätzen für das Magnetresonanzgerät, wobei ein Fett-Konfigurationsparametersatz basierend auf der Fett-BO-Feldkarte und ein Wasser-Konfigurationsparametersatz basierend auf der Wasser-BO-Feldkarte ermittelt werden, wobei der Fett-Konfigurationsparametersatz einen für Fett optimierten Konfigurationsparametersatz bildet und der Wasser-Konfigurationsparametersatz einen für Wasser optimierten Konfigurationsparametersatz bildet,
- Erstellen einer Mess-Pulssequenz basierend auf dem Fett-Konfigurationsparametersatz und dem Wasser-Konfigurationsparametersatz,
- Erfassen von Magnetresonanz-Messdaten des Untersuchungsbereichs des Untersuchungsobjekts basierend auf der Anwendung der Mess-Pulssequenz.

Der Untersuchungsbereich, auch Aufnahmevolumen (field of view, FOV) genannt, stellt insbesondere ein Volumen dar, für welches die Magnetresonanz-Messdaten aufgenommen werden. Für den Untersuchungsbereich können basierend auf den Magnetresonanz-Messdaten Magnetresonanz-Bilddaten rekonstruiert werden, sodass der Untersuchungsbereich abgebildet wird. Der Untersuchungsbereich wird typischerweise durch einen Benutzer, beispielsweise auf einer Übersichtsaufnahme (Localizer), festgelegt. Die Übersichtsaufnahme kann insbesondere basierend auf der Anwendung der Pre-Pulssequenz ermittelt werden. Der Untersuchungsbereich kann alternativ oder zusätzlich automatisch, beispielsweise auf Grundlage eines ausgewählten Protokolls, festgelegt werden. Das Untersuchungsobjekt kann ein Patient, ein Proband, ein Tier oder ein Phantom sein. Die Magnetresonanz-Messdaten werden insbesondere bereitgestellt, beispielsweise als Daten in einer Datenbank gespeichert, und/oder als Magnetresonanz-Bilddaten einem Benutzer auf einer Anzeigeeinheit angezeigt.

Der Untersuchungsbereich weist Wasserstoffatome, auch Protonen genannt, auf, wobei die Wasserstoffatome insbesondere in Wasser oder Fett gebunden sind. Man spricht hierbei auch von fettgebundenen Protonen und von wassergebundenen Protonen. Die fettgebundenen Protonen und die wasserstoffgebundenen Protonen weisen jeweils einen Kernspin auf. Die fettgebundenen Protonen und die wasserstoffgebundenen Protonen weißen in einem äußeren Magnetfeld, insbesondere dem Hauptmagnetfeld BO, unterschiedliche Resonanzfrequenzen auf. Bezüglich üblicher BO-Magnetfeldstärken in Magnetresonanzgeräten beträgt der Unterschied in der Resonanzfrequenz zwischen fettgebundenen Protonen und wasserstoffgebundenen Protonen etwa 3,4 ppm. Die Verteilung von Fett und Wasser ist in dem Untersuchungsbereich üblicherweise nicht gleichmäßig. Es existieren Abschnitte des Untersuchungsbereichs mit unterschiedlichem Wassergehalt bzw. Fettgehalt. In einem Menschen als Untersuchungsobjekt und einem Schulterbereich als Untersuchungsbereich ist Fett üblicherweise mehr im posterioren Bereich angesiedelt und weniger im Nacken- und/oder Schulterbereich.

Das Verfahren umfasst die Messung einer BO-Feldkarte, insbesondere mittels eines dem Fachmann geläufigen Verfahrens. Die Messung der BO erfolgt unter Anwendung und/oder Ausspielens einer Pre-Pulssequenz. Ferner erfolgt das Messen der BO-Feldkarte als ein Pre-Scan bzw. Voraufnahme, mit anderen Worten einer Aufnahme von vorläufigen Magnetresonanz-Messdaten, auch Rohdaten genannt. Eine BO-Feldkarte beschreibt insbesondere eine Feldverteilung eines Hauptmagnetfelds BO des Magnetresonanzgeräts. Die gemessene BO-Feldkarte kann im Speziellen eine Abweichung des physikalischen BO-Feldes von einem idealen konstanten Hauptmagnetfeld des Magnetresonanzgeräts wiedergeben. Die BO-Feldkarte kann damit zum Identifizieren von Inhomogenitäten im Hauptmagnetfeld dienen, die insbesondere dann entstehen, wenn das Untersuchungsobjekt im Magnetresonanzgerät positioniert ist. Die BO-Feldkarte kann als eine hochgenaue BO-Feldkarte BO(x, y, z) ausgebildet sein, die das absolute lokale Magnetfeld oder die absolute Abweichung von einem Mittelwert, beispielsweise in (Mikro-)Tesla oder als Resonanzfrequenz(-verschiebung), enthält. Ein beispielhaftes Verfahren zur Ermittlung einer solchen BO-Feldkarte wird in DE 10 2014 201 207 A1 beschrieben.

Gemäß dem Verfahren wird eine Fett-Maske bereitgestellt. Die Fett-Maske kann als Datensatz bereitgestellt sein, beispielsweise hinterlegt in einem Datenspeicher. Alternativ kann die Fett-Maske ermittelt werden, insbesondere basierend auf und/oder während der Messung der BO-Feldkarte. Die Fett-Maske kann insbesondere eine binäre Maske bilden. Im Speziellen kann es vorgesehen sein, dass eine Wasser-Maske bereitgestellt wird und/oder ermittelt wird. Die Fett-Maske umfasst und/oder stellt die Bereiche des Untersuchungsbereichs dar, die Fett aufweisen, insbesondere einen Fettanteil oder Fettsignal größer als ein Schwellwert aufweisen. Mit anderen Worten beschreibt die Fett-Maske die Bereiche des Untersuchungsbereichs, die von Fett dominiert werden.

Als Masken werden insbesondere Spinartenverteilungskarten G(x,y,z) verstanden, welche im Speziellen zu erwartende Larmorfrequenzverteilungen im Untersuchungsbereich liefern. Die Fett-Maske beschreibt dabei eine Spinartenverteilungskarte bezüglich Protonen bzw. Protonenspins, die in Fett gebunden sind, wobei die Wasser-Maske eine Spinartenverteilungskarte bezüglich Protonen bzw. Protonenspins, die in Wasser gebunden sind, beschreibt. Mit anderen Worten beschreibt eine Spinartenverteilungskarte G(x,y,z) die dominierende Spinart in einem Voxel, das bedeutet, die Spinartenverteilungskarte enthält für jedes Voxel "W" für dominierende Wasserspins und "F" für dominierende Fettspins. Damit können Wasser- und Fettmasken bestimmt werden als: M_{W}(x,y,z) = M(x,y,z), falls G(x,y,z) = "W", sonst 0, bzw. M_{F}(x,y,z) = M(x,y,z) falls G(x,y,z) = "F", sonst 0.

Das Verfahren umfasst das Ermitteln einer Fett-BO-Feldkarte und einer Wasser-BO-Feldkarte basierend auf der gemessenen BO-Feldkarte und der Fett-Maske. Das Untersuchungsobjekt, insbesondere der Untersuchungsbereich, umfasst die wassergebundenen Protonen als eine erste Spinart (auch Spinspezies genannt) und die fettgebundenen Protonen als eine zweite Spinart. Die Fett-BO-Feldkarte beschreibt insbesondere eine Verteilung von Larmorfrequenzen der ersten Spinart, wobei die Wasser-BO-Feldkarte eine Verteilung von Larmorfrequenzen der zweiten Spinart beschreibt. Die Fett-BO-Feldkarte bzw. die Wasser-BO-Feldkarte ist mit anderen Worten auf die jeweilige Spinart bezogen und kann also für jedes Voxel eine Larmorfrequenz der jeweiligen Spinart an diesem Ort mittelbar oder unmittelbar beschreiben. Im Speziellen wird als Fett-BO-Feldkarte bzw. die Wasser-BO-Feldkarte eine Karte verwendet, die an jedem Ort (jedem Voxel) die Resonanzfrequenz (Larmorfrequenz) eines Referenz-Bindungszustands des relevanten Nukleus (beispielsweise Protonen im Bindungszustand des Wassermoleküls) angibt und nicht die Larmorfrequenz des dort tatsächlich vorliegenden Bindungszustands.

Einen Schritt des Verfahrens bildet das Ermitteln von mehreren Konfigurationsparametersätzen für das Magnetresonanzgerät. Hierbei wird ein Fett-Konfigurationsparametersatz basierend auf der Fett-BO-Feldkarte und ein Wasser-Konfigurationsparametersatz basierend auf der Wasser-BO-Feldkarte ermittelt. Mit anderen Worten wird für die zwei Spinarten wassergebundene Protonen und fettgebundene Protonen jeweils ein Konfigurationsparametersatz ermittelt. Insbesondere erfolgt das Ermitteln des Fett-Konfigurationsparametersatzes unabhängig von der Wasser-BO-Feldkarte und/oder das Ermitteln des Wasser-Konfigurationsparametersatzes erfolgt unabhängig von der Fett-BO-Feldkarte. Der Fett-Konfigurationsparametersatz wird beispielsweise durch Optimieren aller oder einer Teilmenge von Konfigurationsparametern des Magnetresonanzgerätes bezüglich Fetts und/oder der Fett-BO-Feldkarte ermittelt. Der Wasser-Konfigurationsparametersatz wird beispielsweise durch Optimieren aller oder einer Teilmenge von Konfigurationsparametern des Magnetresonanzgerätes bezüglich Wasser und/oder der Fett-BO-Feldkarte ermittelt. Optimiert bezüglich Fetts oder Wasser wird insbesondere so verstanden, dass das jeweilige Gewebe (Fett oder Wasser) relativ zum anderen Gewebe (Wasser oder Fett) besser erfasst und/oder abgebildet wird, beispielsweise kontrastreicher erfasst wird.

In einem weiteren Schritt des Verfahrens wird basierend auf dem Fett-Konfigurationsparametersatz und dem Wasser-Konfigurationsparametersatz eine Mess-Pulssequenz erstellt und/ oder generiert. Beispielsweise wird die Mess-Pulssequenz hierzu in Pulssequenzabschnitte aufgeteilt, wobei die Pulssequenzabschnitte jeweils auf eine Spinart, im Speziellen auf Wasser, Fett oder beides, ausgerichtet bzw. optimiert ist. Hierzu kann das Erstellen der Mess-Pulssequenz ein Zuordnen des Fett-Konfigurationsparametersatzes und des Wasser-Konfigurationsparametersatzes zu den verschiedenen Pulssequenzabschnitten umfassen. Insbesondere werden die Pulssequenzabschnitte basierend auf dem Fett- und Wasser-Konfigurationsparametersatz optimiert und/oder bestimmt, im Speziellen separat und/oder unabhängig optimiert und/oder bestimmt. Zum Beispiel umfasst die Mess-Pulssequenz als einen Pulssequenzabschnitt einen STIR-Puls, einen Fettsättigungspuls oder einen SPAIR-Puls, wobei diese für eine effiziente Fettunterdrückung optimiert werden, insbesondere basierend auf dem Fett-Konfigurationsparametersatz. Ferner kann die Mess-Pulssequenz als einen Pulssequenzabschnitt einen Standard-Anregungspuls, einen Refokussierungspuls für die Fett-Sat-Bildgebung, einen EPI-Echozug, einen Magnetisierungsübertragungspuls und/oder einen Wasserunterdrückungspuls als Pulssequenzabschnitt umfassen, wobei diese für die spektroskopische Bildgebung für Wasser optimiert werden, insbesondere basierend auf dem Wasser-Konfigurationsparametersatz. Anregungs- oder Refokussierungspulse für fettfreie Sat- oder DIXON-Pulssequenzen werden für beide Spinarten optimiert, insbesondere basierend auf dem Wasser-Konfigurationsparametersatz und dem Fett-Konfigurationsparametersatz.

In einem weiteren Schritt des Verfahrens werden die Magnetresonanz-Messdaten des Untersuchungsbereichs des Untersuchungsobjekts ermittelt und/oder aufgenommen. Hierzu wird die Mess-Pulssequenz angewendet und/oder ausgespielt. Durch das Anwenden der Mess-Pulssequenz werden insbesondere die Pulssequenzabschnitte angewendet und/oder ausgespielt, sodass optimierte und verbesserte Magnetresonanz-Messdaten aufgenommen werden können. Magnetresonanz-Messdaten können beispielsweise mittels Einstrahlens von RF-Pulsen und dem Anlegen von Schichtselektionsgradienten, Phasenkodiergradienten und Frequenzkodiergradienten und Aufnehmen der resultierenden Magnetresonanz-Signale mittels einer Hochfrequenz-Spule erfasst werden, wobei der zeitliche Ablauf und/oder die Werte der einzelnen Stellgrößen von der Mess-Pulssequenz festgelegt ist. Dabei sind die Magnetresonanz-Messdaten typischerweise nur die Rohdaten, welche die erfassten Magnetresonanz-Signale nach Demodulation enthalten. Somit stehen die Magnetresonanz-Messdaten typischerweise nicht direkt für eine fachkundige Person zur Diagnose zur Verfügung. Vielmehr werden unter Verwendung der Magnetresonanz-Messdaten Magnetresonanz-Bilddaten, welche typischerweise zumindest einen Magnetresonanz-Bilddatensatz umfassen, rekonstruiert. Die Magnetresonanz-Bilddaten können dann auf einer Anzeigeeinheit dargestellt werden und einer fachkundigen Person, z.B. einem Radiologen, zur Erstellung einer Diagnose zur Verfügung gestellt werden.

Der Erfindung liegt die Überlegung zugrunde, dass die Verteilung der fett- und wasserdominanten Bereiche im Untersuchungsobjekt, insbesondere im Untersuchungsbereich, je nach Körperregion und Schnittausrichtung stark variieren kann. Bisher wurde die Mess-Pulssequenz global für eine Mischung der Spinarten oder nur für Wasser optimiert, wobei dies nicht immer optimale Korrekturergebnisse liefern kann. Im Gegensatz hierzu verwendet die vorliegende Erfindung Fett-Maske zusammen mit der BO-Feldkarte, um Pulssequenzabschnitte für verschiedene Spinarten zu optimieren, was zu qualitativ hochwertigeren Magnetresonanz-Messdaten und daraus rekonstruierten Magnetresonanzbildern führt. Ferner kann die Zeit zur Beschaffung nötiger Informationen und Randbedingungen sowie die Zeit zur Einstellung der Magnetresonanzgerätparameter drastisch reduziert werden.

Im Verfahrensschritt Erstellen der Mess-Pulssequenz wird vorzugsweise ein Pulssequenzabschnitt basierend auf dem Fett-Konfigurationsparametersatz ermittelt und/oder optimiert. Vorzugsweise wird ein weiterer Pulssequenzabschnitt basierend auf dem Wasser-Konfigurationsparametersatz ermittelt und/oder optimiert.

Die Konfigurationsparametersätze, die Mess-Pulssequenz und/ oder die Pulssequenzabschnitte können als mögliche Parameter eine Lage und/oder eine Breite und/oder eine Form eines Anregungsspektrums umfassen. Ferner können die Konfigurationsparametersätze, die Mess-Pulssequenz und/oder die Pulssequenzabschnitte Charakterisierungen einzelner Pulse umfassen, wie beispielsweise Form (z.B. Gaußform), Lage (Mittenfrequenz) und/oder Bandbreite. Ferner können als Parameter zeitliche Abstände zwischen Pulsen und/oder Puls und Aufnahme vorgesehen sein. Selbstverständlich sind grundsätzlich auch andere zu optimierende Parameter als Teil der Konfigurationsparametersätze, der Mess-Pulssequenz und/oder der Pulssequenzabschnitte denkbar.

Die Pulssequenzabschnitte können im Speziellen basierend auf dem Fett-Konfigurationsparametersatz und/oder dem Wasser-Konfigurationsparametersatz sowie einem Qualitätskriterium ermittelt und/oder optimiert werden. Das Qualitätskriterium kann beispielsweise eine Minimierung oder Maximierung der Anregung oder Unterdrückung einer Spinart bilden. Das Qualitätskriterium im Allgemeinen bzw. das Minimierungs- oder Maximierungskriterium im Speziellen kann dabei, wie grundsätzlich im Stand der Technik bekannt, durch eine Zielfunktion beschrieben werden, wobei verschiedene Kriterien unterschiedlich gewichtet in die Zielfunktion eingehen können. Zudem sei an dieser Stelle angemerkt, dass zur algorithmischen Umsetzung der Optimierung grundsätzlich im Stand der Technik bekannte Optimierungsverfahren herangezogen werden können, beispielsweise gradientenbasierte Optimierungsalgorithmen und dergleichen.

Vorzugsweise erfolgt das Ermitteln des Wasser-Konfigurationsparametersatzes unabhängig von dem Ermitteln des Fett-Konfigurationsparametersatzes. Ferner erfolgt vorzugsweise auch das Ermitteln des Fett-Konfigurationsparametersatzes unabhängig von dem Ermitteln des Wasser-Konfigurationsparametersatzes. Es kann aber auch eine Ausgestaltung umfasst sein, bei der ein Misch-Konfigurationsparametersatz bestimmt wird, der basierend auf der Fett-BO-Feldkarte und der Wasser-BO-Feldkarte bestimmt wird und beispielsweise eine Berücksichtigung und/oder Optimierung beider Spinarten bildet.

Eine Ausgestaltung der Erfindung sieht vor, dass während, bei und/oder basierend auf der Messung der BO-Feldkarte und der Anwendung der Pre-Pulssequenz eine Resonanzfrequenz von in Wasser und/oder in Fett gebundenen Protonen ortsaufgelöst ermittelt wird. Mit anderen Worten wird hierbei eine ortsaufgelöste Kartierung der Resonanzfrequenz von wassergebundenen Protonen und/oder von fettgebundenen Protonen bestimmt. Basierend auf der gemessenen ortsaufgelösten Resonanzfrequenz des fettgebundenen Protons bzw. deren Kartierung kann beispielsweise die Fett-Maske bestimmt werden und/oder basierend auf der gemessenen ortsaufgelösten Resonanzfrequenz der wassergebundenen Protonen bzw. deren Kartierung kann beispielsweise eine Wasser-Maske bestimmt werden.

Zur Messung der BO-Feldkarte, insbesondere zur ortsaufgelösten Messung der Resonanzfrequenzen, mittels der Pre-Pulssequenz können Magnetresonanzdaten, vorzugsweise mittels Gradientenecho-Bildgebung zu zwei verschiedenen Echozeiten, aufgenommen werden. Die Phasendifferenz (Phasenänderung) der zu unterschiedlichen Echozeiten aufgenommenen Magnetresonanzdaten, die beispielsweise durch Subtraktion der Phasen zweier zu unterschiedlichen Echozeiten aufgenommener Magnetresonanz-Messdaten ermittelt werden kann, ist proportional zur Abweichung des lokalen BO-Feldes von der Nenn-Grundmagnetfeldstärke und zur Dephasierungszeit.

Im Stand der Technik sind Verfahren bekannt, die zur Messung der BO-Feldkarte und der ortsaufgelösten Messung der Resonanzfrequenzen angewendet werden können. Beispielsweise ist in einem Artikel von J. Dagher et al, "High-resolution, large dynamic range field map estimation", Magn. Reson. Med. 71 (2014) 105-117, hierfür ein sogenanntes "Multi-Echo-Verfahren" beschrieben. Wesentlich für eine hochqualitative und verlässliche Bestimmung der BO-Feldkarte ist die Wahl der Dephasierungszeiten. Hierzu ist es aus einem Artikel von Joseph Dagher et al., "A method for efficient and robust estimation of low noise, high dynamic range BO maps ", Proc. Intl. Soc. Mag. Reson. Med. 20 (2012), Seite 613, bekannt, einen Optimierungszugang zur Bestimmung der Dephasierungszeiten zu verwenden, der auf simulierter Abkühlung (simulated annealing) beruht, wobei auch andere Varianten bereits vorgeschlagen wurden.

Die Spinarten, fettgebundene und wassergebundene Protonen, weisen basierend auf der chemischen Bindung und der chemischen Verschiebung bei gegebenem BO-Feld unterschiedliche Resonanzfrequenzen auf. Daher ergeben sich für Komponenten unterschiedlicher chemischer Bindung, beispielsweise in Fett und Wasser gebundenen Protonen, verschiedene Larmorfrequenzen bei gleichem BO-Feld. Zwischen Fett und Wasser macht dieser Unterschied in etwa 3,4 ppm aus.

Phasenbasierte Verfahren zur Messung der BO-Feldkarte messen, wie dargelegt wurde, als BO-Feldkarte häufig die räumliche Verteilung der Abweichungen der Resonanzfrequenzen von der Nenn-Larmorfrequenz des Magnetresonanzgerätes. Die Nenn-Larmorfrequenz eines Magnetresonanzgerätes bezieht sich üblicherweise auf in Wasser gebundene Protonen, so dass die Larmorfrequenzwerte in der BO-Feldkarte nur dann den BO-Abweichungen entsprechen, wenn die Resonanzfrequenz von WasserSpins betrachtet wird. Existieren im Untersuchungsvolumen beispielsweise sowohl Fett- als auch Wasserbereiche, also Bereiche, in denen mehr in Fett gebundene Protonen bzw. mehr in Wasser gebundene Protonen vorliegen, wird in diesen auch bei konstantem BO-Feld eine unterschiedliche Larmorfrequenz gemessen. Dieses Problem tritt bei den Multi-Echo-Verfahren neu auf, da die meisten anderen bekannten BO-Mapping-Verfahren typischerweise Messungen "in Phase" durchführen, das bedeutet, die relativen Phasenlagen von in Wasser und in Fett gebundenen Protonen sind deckungsgleich und führen zu keiner Phasendifferenz, mithin auch nicht zu Artefakten aufgrund der chemischen Verschiebung. Beispielhaft sei hier auf die im Standardwerk von M. A. Bernstein, K. F. King und X. J. Zhou, "Handbook of MRI pulse sequences", Elsevier Academic Press, 2004, genannten BO-Mapping-Verfahren verwiesen. Bei diesen Verfahren treten allerdings viele Phasenwraps auf, welche als kritischer einzustufen sind.

Eine Ausgestaltung der Erfindung sieht vor, zur Ermittlung der BO-Feldkarte und/oder der Fett-Maske eine Messdatenaufnahme mittels eines Multi-Echo-Verfahrens durchzuführen, wobei vorzugsweise verschiedene Dephasierungszeiten verwendet werden. Typischerweise äußert sich die chemische Verschiebung durch eine sprunghafte Abhebung der fetthaltigen Regionen innerhalb der BO-Feldkarte. Daher ist es besonders bevorzugt, die BO-Feldkarte mittels eines die Unterschiede der Larmorfrequenzwerte benachbarter Bildpunkte der BO-Feldkarte bewertenden Segmentierungskriteriums in wenigstens zwei zusammenhängende, insbesondere wenigstens zwei Bildpunkte enthaltende, Cluster, die durch einen Sprung der Larmorfrequenzwerte getrennt sind, segmentiert wird, wonach für jedes Cluster anhand eines Glattheitskriteriums und im Speziellen eines Kompaktheitskriteriums entschieden wird, ob es sich um ein mehrheitlich in Fett gebundene Protonen enthaltendes Cluster handelt. Zur Ermittlung der BO-Feldkarte kann bei einem Cluster, das als mehrheitlich in Fett gebundene Protonen enthaltend identifiziert wurde, durch Erniedrigung der Larmorfrequenzwerte um die Differenz zwischen der Nenn-Larmorfrequenz für in Wasser gebundene Protonen und der entsprechenden Nenn-Larmorfrequenz für in Fett gebundene Protonen eine Korrektur erfolgen.

Beispielsweise wird die BO-Feldkarte, insbesondere die aus dem Multi-Echo-Verfahren berechnete BO-Feldkarte, in eine Menge von Clustern zerlegt. Ein Cluster ist eine Menge zusammenhängender Bildpunkte, also von Pixeln oder Voxeln, die sich zumindest in eingeschränkten Nachbarschaften in ihren Larmorfrequenzwerten (Frequenzabweichungen) nur äußerst wenig unterscheiden, mithin einen äußerst glatten, flachen Verlauf der Larmorfrequenzwerte zeigen. Konkret bedeutet das, dass die Larmorfrequenzwerte in Nachbarschaften des Clusters äußerst eng beieinanderliegen, mithin vergleichbar sind. Dennoch kann das Ergebnis der Segmentierung ein Cluster sein, das an entgegengesetzten Seiten deutlicher unterschiedliche Larmorfrequenzwerte aufweist, jedoch ist der Verlauf dazwischen dann äußerst glatt ohne starken Gradienten, was durch die Betrachtung von Nachbarschaftsbeziehungen gelingt. Cluster beschreiben somit auch Bereiche im Untersuchungsobjekt, die gebundene Protonen enthalten. Insbesondere ist für weitere Ausgestaltungen und weitere Details auf die Druckschrift DE 10 2014 201 207 B4 verwiesen, deren Inhalt hiermit aufgenommen wird.

Optional sieht das Verfahren vor, dass eine Bl-Feldkarte ermittelt wird. Die Bl-Feldkarte wird vorzugsweise durch die Anwendung der Pre-Pulssequenz und/oder während des Schritts zur Messung der BO-Feldkarte ermittelt. Insbesondere wird die Bl-Feldkarte gemessen und/oder basierend auf Messdaten bestimmt. Diese Ausgestaltung sieht vor, dass der Fett-Konfigurationsparametersatz basierend auf der Fett-BO-Feldkarte und der Bl-Feldkarte ermittelt wird. Alternativ und/oder ergänzend ist es vorgesehen, dass der Wasser-Konfigurationsparametersatz basierend auf der Bl-Feldkarte sowie der BO-Feldkarte oder basierend auf der Bl-Feldkarte sowie der Fett-BO-Feldkarte ermittelt wird.

Ferner kann es optional vorgesehen sein, dass basierend auf der Bl-Feldkarte und der Fett-Maske eine Fett-Bl-Feldkarte ermittelt wird. Alternativ und/oder ergänzend kann basierend auf der der Bl-Feldkarte und der Fett- oder Wasser-Maske eine Wasser-Bl-Feldkarte ermittelt werden. Basierend auf der Fett-Bl-Feldkarte und der Fett-BO-Feldkarte wird optional der Fett-Konfigurationsparametersatz ermittelt. Alternativ und/ oder ergänzend kann beispielswese basierend auf der Wasser-Bl-Feldkarte und der Wasser-BO-Feldkarte der Wasser-Konfigurationsparametersatz ermittelt werden.

Optional ist es vorgesehen, dass der Fett-Konfigurationsparametersatz eine für in Fett gebundene Protonen optimierte Resonanzfrequenz, insbesondere Zentralfrequenz, umfasst. Das Ermitteln der Fett-Bl-Feldkarte aus der Bl-Feldkarte und der Fett-Maske kann angelehnt bzw. analog zur Ermittlung der Fett-BO-Feldkarte aus der BO-Feldkarte und der Fett-Maske erfolgen. Das Ermitteln der Wasser-Bl-Feldkarte aus der B1-Feldkarte und der Wasser- oder Fett-Maske kann angelehnt bzw. analog zur Ermittlung der Wasser-BO-Feldkarte aus der BO-Feldkarte und der Wasser- oder Fett-Maske erfolgen.

Besonders bevorzugt umfasst der Fett-Konfigurationsparametersatz ein für Fett optimiertes BO-Shimming, insbesondere ein BO-Shimming erster Ordnung und im Speziellen ein BO-Shimming höherer Ordnung. Das BO-Shimming erster Ordnung ist vorzugsweise als ein BO-Gradienten-Shimming ausgebildet. Der Konfigurationsparametersatz umfasst hierzu insbesondere einen Shimparametersatz für eine Shimeinheit des Magnetresonanzgeräts. Der Shimparametersatz kann Einstellungen für eine Ansteuerung der Shimeinheit des Magnetresonanzgeräts, insbesondere von mindestens einem Shimkanal der Shimeinheit, umfassen. Beispielsweise kann der Shimparametersatz einen Strom für den mindestens einen Shimkanal festlegen. Insbesondere kann der Konfigurationsparametersatz, der Fett-, der Wasser-Konfigurationsparametersatz und/oder der Shimparametersatz einen geeigneten Wert für RF-Mittenfrequenz und/oder Resonanzfrequenz umfassen.

Eine Ausführung der Erfindung sieht vor, dass der Fett-Konfigurationsparametersatz ein für Fett optimiertes B1-Shimming umfasst und/oder der Wasser-Konfigurationsparametersatz ein für Wasser optimiertes Bl-Shimming umfasst. Hierzu können Bl-Shimmingparameter als Teil des Fett-Konfigurationsparametersatzes bestimmt werden, wobei die B1-Shimmingparameter insbesondere basierend auf der Bl-Feldkarte und/oder der Fett-Bl-Feldkarte bestimmt werden. Bl-Shimmingparameter des Wasser-Konfigurationsparametersatzes können basierend auf der Bl-Feldkarte und/oder der Wasser-Bl-Feldkarte bestimmt werden.

Die Konfigurationsparametersätze, insbesondere die Fett- und/oder Wasser-Konfigurationsparametersätze, können als Parameter ferner beispielsweise eine jeweilige Zentralfrequenz (z.B. für eine verbesserte Fettunterdrückung und/oder eine reduzierte EPI-Bild-Verschiebung), ein Shimming des BO-Feldes in erster Ordnung (z.B. für eine homogenere Fettunterdrückung und/oder ein verbessertes Signal-Rausch-Verhältnis (SNR)) und/oder eine jeweilige Spannung der RF-Sende-Einheiten (z.B. für ein verbessertes SNR) umfassen.

Besonders bevorzugt werden die Konfigurationsdatensätze, insbesondere der Fett- und/oder Wasser-Konfigurationsparametersatz, und/oder die Mess-Pulssequenz schichtabhängig ermittelt. Unter schichtabhängiges Ermitteln wird insbesondere verstanden, dass die zu ermittelnden Parameter, Konfigurationsparametersätze und/oder Mess-Pulssequenzen jeweils für eine Schicht des Untersuchungsbereichs ermittelt werden. Alternativ können die zu ermittelnden Parameter, Konfigurationsparametersätze und/oder Mess-Pulssequenzen für Volumenabschnitte oder einen Stapel (Stack) aus mehreren Schichten ermittelt werden. Dies basiert auf der Überlegung, dass eine Kompensation von lokalen Feldverzerrungen umso vollständiger funktioniert, je kleiner ein Volumen ist, in dem das Hauptmagnetfeld homogenisiert werden soll. Es kann deshalb Sinn machen, verschiedene Konfigurationsparametersätze und/oder Mess-Pulssequenzen separat für Schichten bzw. Teilbereiche des Untersuchungsbereichs zu ermitteln.

Einen weiteren Gegenstand der Erfindung bildet ein Magnetresonanzgerät. Das Magnetresonanzgerät umfasst vorzugsweise eine Magneteinheit, eine Gradienteneinheit, eine Hochfrequenzeinheit und/oder eine Shimeinheit. Alternativ und/oder ergänzend umfasst das Magnetresonanzgerät eine Steuereinheit zur Ausführung des erfindungsgemäßen Verfahrens. Das Magnetresonanzgerät ist somit ausgebildet und/oder eingerichtet, das Verfahren zur Magnetresonanz-Bildgebung eines Untersuchungsobjekts in einem Untersuchungsbereich mittels eines Magnetresonanzgeräts auszuführen und/oder anzuwenden.

Das Magnetresonanzgerät umfasst:
- Eine Messeinheit, wobei die Messeinheit ausgebildet ist, eine BO-Feldkarte des Untersuchungsbereichs basierend auf der Anwendung einer Pre-Pulssequenz zu messen und/oder zu ermitteln,
- Eine Maskenbereitstellungseinheit, wobei die Maskenbereitstellungseinheit ausgebildet ist, eine Fett-Maske für den Untersuchungsbereich bereitzustellen, insbesondere die Fett-Maske basierend auf der Anwendung der Pre-Pulssequenz zu bestimmen,
- Eine Maskierungseinheit, wobei die Maskierungseinheit ausgebildet ist, eine Fett-BO-Feldkarte und eine Wasser-BO-Feldkarte basierend auf der gemessenen BO-Feldkarte und der Fett-Maske zu ermitteln,
- Eine Konfigurationsparameterbestimmungseinheit zur Ermittlung mehrerer Konfigurationsparametersätze für das Magnetresonanzgerät, wobei die Konfigurationsparameterbestimmungseinheit ausgebildet ist, einen Fett-Konfigurationsparametersatz basierend auf der Fett-BO-Feldkarte und einen Wasser-Konfigurationsparametersatz basierend auf der Wasser-BO-Feldkarte zu ermitteln, wobei der Fett-Konfigurationsparametersatz einen für Fett optimierten Konfigurationsparametersatz bildet und der Wasser-Konfigurationsparametersatz einen für Wasser optimierten Konfigurationsparametersatz bildet,
- Eine Pulssequenzerstellungseinheit, wobei die Pulssequenzerstellungseinheit ausgebildet ist, eine Mess-Pulssequenz basierend auf dem Fett-Konfigurationsparametersatz und dem Wasser-Konfigurationsparametersatz zu erstellen und/oder zu bestimmen,
- Eine Messdatenerfassungseinheit, wobei die Messdatenerfassungseinheit ausgebildet ist, Magnetresonanz-Messdaten des Untersuchungsbereichs des Untersuchungsobjekts basierend auf der Anwendung der Mess-Pulssequenz zu erfassen.

Ferner betrifft die Erfindung ein Computerprogramm. Das Computerprogramm ist direkt in einen Speicher einer programmierbaren Steuereinheit eines Magnetresonanzgeräts ladbar und/ oder weist Programmcode-Mittel auf, um das erfindungsgemäße Verfahren auszuführen, wenn das Computerprogramm in der Steuereinheit des Magnetresonanzgeräts ausgeführt wird.

Einen weiteren Gegenstand der Erfindung bildet ein Speichermedium, wobei das Computerprogramm auf dem Speichermedium gespeichert ist. Das Speichermedium ist als ein maschinenlesbarer und/oder elektronisch lesbarer Datenträger ausgebildet, beispielsweise als eine DVD, ein Magnetband oder ein USB-Stick.

Die Vorteile des erfindungsgemäßen Magnetresonanzgeräts und des erfindungsgemäßen Computerprogramms entsprechen im Wesentlichen den Vorteilen des erfindungsgemäßen Verfahrens, welche vorab im Detail ausgeführt sind. Hierbei erwähnte Merkmale, Vorteile oder alternative Ausführungsformen sind ebenso auch auf die anderen beanspruchten Gegenstände zu übertragen und umgekehrt. Mit anderen Worten können die gegenständlichen Ansprüche auch mit den Merkmalen, die in Zusammenhang mit einem Verfahren beschrieben oder beansprucht sind, weitergebildet sein. Die entsprechenden funktionalen Merkmale des Verfahrens werden dabei durch entsprechende gegenständliche Module, insbesondere durch Hardware-Module, ausgebildet.

Weitere Vorteile, Wirkungen und Ausgestaltungen ergeben sich aus den beigefügten Figuren und deren Beschreibung. Dabei zeigen:
- Fig. 1: einen Ablaufplan eines Ausführungsbeispiels des erfindungsgemäßen Verfahrens,
- Fig. 2: eine mögliche Verteilung von wasser- und fett gebundenen Protonen in einem Untersuchungsbereich,
- Fig. 3a, b: einen beispielhaften Ausschnitt aus einer Mess-Pulssequenz,
- Fig. 4: schematisch ein erfindungsgemäßes Magnetresonanzgerät.

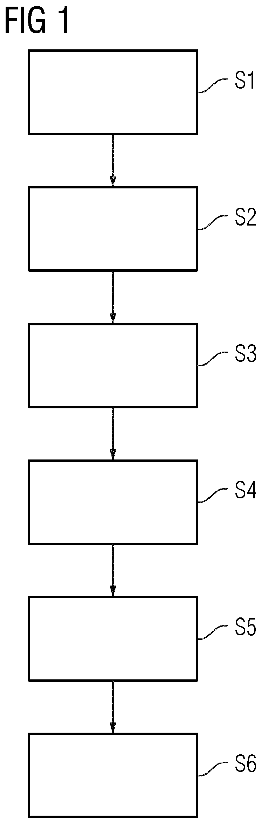

Fig. 1 zeigt einen Ablaufplan eines Ausführungsbeispiels eines erfindungsgemäßen Verfahrens. Von einem Untersuchungsbereich eines Patienten als ein Untersuchungsobjekt sollen Magnetresonanz-Messdaten aufgenommen werden, die insbesondere zur Magnetresonanz-Bildgebung herangezogen werden können. Der Untersuchungsbereich bzw. der Patient umfasst Wasserstoffatome, welche in Fett gebunden sind (fettgebundene Protonen) oder in Wasser gebunden sind (wassergebundene Protonen).

In einem Schritt S1 wird eine Pre-Pulssequenz ausgespielt bzw. angewendet. Hierbei werden Magnetresonanzdaten als Rohdaten erfasst bzw. aufgenommen. Basierend auf den Rohdaten wird dann eine BO-Feldkarte ermittelt. Die BO-Feldkarte bezieht sich insbesondere auf einen Referenz-Bindungszustand der Protonen (Wasserstoffkerne), vorliegend auf den Bindungszustand von Protonen in Wassermolekülen. Sie enthält im vorliegenden Ausführungsbeispiel vorzugsweise absolute Werte von Larmorfrequenzen, die Wasserspins in den entsprechenden Voxeln aufgrund der Grundfeldverteilung hätten.

In einem Schritt S2 wird eine Fett-Maske bereitgestellt, wobei im vorliegenden Ausführungsbeispiel die Fett-Maske basierend auf den Rohdaten und/oder der Anwendung der Pre-Pulssequenz ermittelt wird. Die Fett-Maske kann basierend auf einer Spinartenverteilungskarte G(x,y,z) bestimmt werden, welche, beispielsweise bei der Unterscheidung von Wasserspins und Fettspins, auch als eine Gewebezuordnungskarte verstanden werden kann. Dabei kann die Spinartenverteilungskarte G(x,y,z) entweder im Wesentlichen binär angeben, ob in einem bestimmten Voxel Wasserspins (wassergebundene Protonen) oder Fettspins (fettgebundene Protonen) dominieren, oder es ist auch denkbar, dass die Spinartenverteilungskarte G(x,y,z) relative Anteile der jeweiligen Spinarten in dem jeweiligen Voxel beschreibt. Die BO-Feldkarte und die Spinartverteilungskarte G(x,y,z) werden bevorzugt gemeinsam in einem Verfahren bestimmt, wie es in DE 10 2014 201 207 A1 beschrieben ist.

Die Fett-Maske beschreibt im Wesentlichen, ob ein Subbereich des Untersuchungsbereichs, z.B. einzelne Voxel, einen Fettbereich oder Wasserbereich bildet. Mit anderen Worten, ob der Subbereich mehrheitlich fettgebundene Protonen umfasst, oder beispielsweise wassergebundene Protonen umfasst.

In einem Schritt S3 wird dann eine Fett-BO-Feldkarte ermittelt. Die Fett-BO-Feldkarte wird basierend auf der BO-Feldkarte und der Fett-Maske ermittelt. Die Fett-BO-Feldkarte kann beispielsweise eine BO-Feldkarte bilden, die sich statt auf wassergebundene Protonen auf fettgebundene Protonen bezieht. Beispielsweise beschreibt die Fett-BO-Feldkarte die Resonanzfrequenzen bzw. die Abweichungen der Resonanzfrequenzen von fettgebundenen Protonen im Untersuchungsbereich. Insbesondere kann ferner eine Wasser-BO-Feldkarte ermittelt werden, welche wassergebundene Protonen als Referenz anwendet. Optional ist eine Bl-Feldkarte für den Untersuchungsbereich bereitgestellt und/oder wird im Verfahrensschritt S1 gemessen. Im Verfahrensschritt S3 kann es daher vorgesehen sein, dass basierend auf der Bl-Feldkarte und der Fett-Maske eine Fett-Bl-Feldkarte und/oder eine Wasser-Bl-Feldkarte ermittelt wird. Die Fett-Bl-Feldkarte bezieht sich dabei auf fettgebundene Protonen und die Wasser-Bl-Feldkarte bezieht sich auf wassergebundene Protonen.

In einem Schritt S4 werden mindestens zwei Konfigurationsparametersätze für das Magnetresonanzgerät bestimmt. Dabei wird ein Fett-Konfigurationsparametersatz basierend auf der Fett-BO-Feldkarte bestimmt, wobei der Fett-Konfigurationsparametersatz z.B. durch Bestimmen von Konfigurationsparametern des Magnetresonanzgeräts bestimmt wird, wobei die Konfigurationsparameter auf die Aufnahme von Fett ausgerichtet und/ oder optimiert sind. Ferner wird ein Wasser-Konfigurationsparametersatz basierend auf der Wasser-BO-Feldkarte ermittelt, wobei der Wasser-Konfigurationsparametersatz zur Aufnahme von Magnetresonanzdaten auf wassergebundene Protonen optimiert ist.

In einem Verfahrensschritt S5 wird eine Mess-Pulssequenz bestimmt. Die Mess-Pulssequenz umfasst Pulssequenzabschnitte. Die Mess-Pulssequenz wird basierend auf den Konfigurationsparametersätzen, insbesondere dem Fett- und dem Wasser-Konfigurationsparametersatz, ermittelt. Die Pulssequenzabschnitte bilden beispielsweise Abschnitte der Mess-Pulssequenz, die auf verschiedenen Spinarten, im Speziellen auf die verschieden gebundenen Protonen, ausgerichtet und/oder optimiert sind. Beispielsweise wird ein Pulssequenzabschnitt basierend auf dem Fett-Konfigurationsparametersatz bestimmt, z.B. durch Anwenden der Parameter des Fett-Konfigurationsparametersatzes. Vorzugsweise wird ferner ein Pulssequenzabschnitt basierend auf dem Wasser-Konfigurationsparametersatz bestimmt, z.B. durch Anwenden der Parameter des Wasser-Konfigurationsparametersatzes. Optional kann ein Pulssequenzabschnitt auf eine Mischung von fett- und wassergebundenen Protonen ausgerichtet sein und bestimmt werden. Beispielsweise wird der auf die Mischung ausgerichtete Pulssequenzabschnitt basierend auf der ursprünglichen bzw. nicht basierend auf der Fett-Maske angepassten, BO-Feldkarte ermittelt.

In einem Verfahrensschritt S6 wird die Mess-Pulssequenz angewendet, wobei die dadurch bestimmten Pulse ausgesendet werden. Auf die Mess-Pulssequenz abgestimmt werden Aufnahmefenster zur Aufnahme der Messsignale festgelegt. Für den Untersuchungsbereich werden somit Magnetresonanz-Messdaten aufgenommen, die separat auf Fett als auch auf Wasser optimiert sind. Basierend auf den Magnetresonanz-Messdaten kann eine Bildrekonstruktion vorgesehen sein, wobei die Bildrekonstruktion im Speziellen die BO-Feldkarte, die Fett- oder Wasser-BO-Feldkarte, als Zusatzinformation nutzt. Die Magnetresonanz-Messdaten werden in einem Speicher gespeichert oder ein rekonstruiertes Magnetresonanzbild auf einer Anzeige angezeigt.

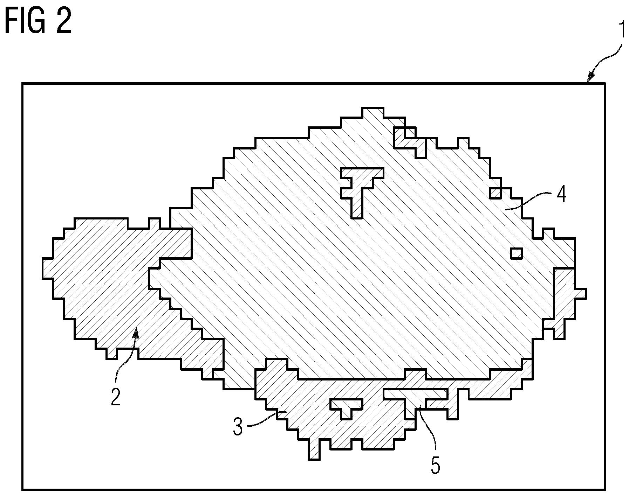

Figur 2 zeigt schematisch einen Ausschnitt aus einer BO-Feldkarte 1 eines Überwachungsbereichs. Die BO-Feldkarte umfasst Pixel. Die Pixel umfassen als Information eine Resonanzfrequenz des Orts im Untersuchungsbereich. Die BO-Feldkarte 1 umfasst bzw. beschreibt Cluster 2, 3, 4, 5. Die Cluster beschreiben Bereiche gleicher bzw. ähnlicher Resonanzfrequenz. Die Cluster 2, 3, 4, 5 beschreiben unterschiedliche Gewebe des Untersuchungsbereichs, bzw. Bereiche mit fettgebundenen und/oder wassergebundenen Protonen. Die Cluster 2, 3, 4, 5 sind basierend auf einem Glattheitskriterium und einem Kompaktheitskriterium bestimmt. Ferner umfasst die BO-Feldkarte 1 Abschnitte, an denen kein Signal erfasst wurde, insbesondere die Bereiche außerhalb des Untersuchungsbereichs.

Aus der BO-Feldkarte 1 bzw. basierend auf deren Messung sind somit die Cluster identifizierbar und den Spinarten zuzuordnen, also ob es sich um ein Wassercluster (wassergebundene Protonen) oder um ein Fettcluster (fettgebundene Protonen) handelt. Vorliegend handelt es sich bei den Clustern 2, 3 um Fettcluster, bzw. Bereiche mit vorwiegend fettgebundenen Protonen. Bei den Clustern 4, 5 handelt es sich um Wassercluster, bzw. um Bereiche mit vorwiegend wassergebundenen Protonen. Die vorliegende geclusterte BO-Feldkarte beschreibt mittels der Cluster 2, 3 eine Fett-Maske, bzw. Abschnitte davon, wobei die Cluster 4, 5 eine Wasser-Maske beschreiben.

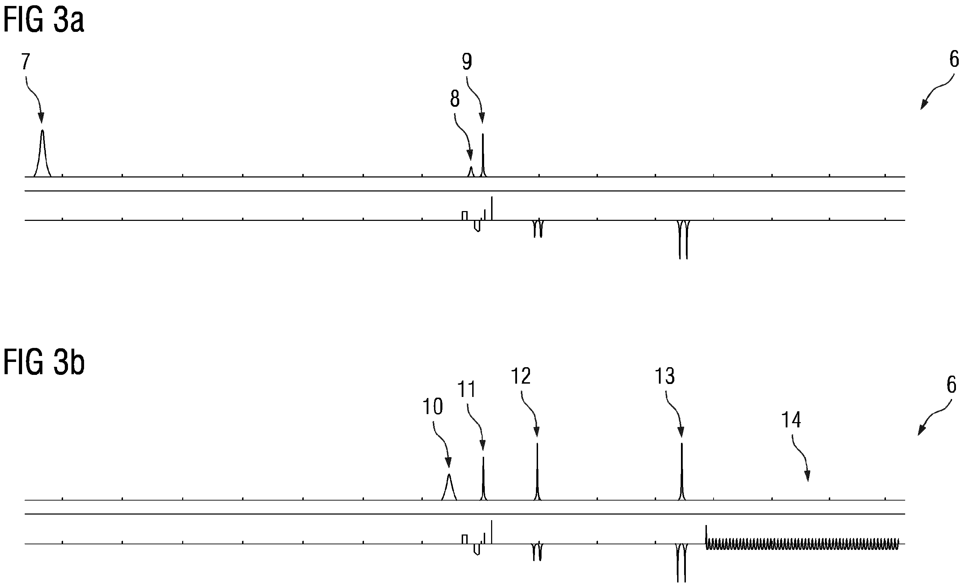

Die Figuren 3a, b zeigen jeweils einen Ausschnitt aus einer Mess-Pulssequenz. Die gezeigten Ausschnitte der Mess-Pulssequenz sind Teil bzw. bilden eine EPI-Pulssequenz. Der in Fig. 3a gezeigte Abschnitt bildet einen basierend auf der Fett-BO-Feldkarte ermittelten Pulssequenzabschnitt 6 und ist auf die Aufnahme von Magnetresonanz-Messdaten eines Untersuchungsbereichs optimiert, der vorwiegend fettgebundene Protonen umfasst. Wohingegen der in Fig. 3b gezeigte Abschnitt einen Pulssequenzabschnitt 6 bildet, der basierend auf der BO-Feldkarte 1, bzw. einer Wasser-BO-Feldkarte, ermitteltet wurde, wobei der Pulssequenzabschnitt 6 bezüglich der Aufnahme von Magnetresonanz-Messdaten eines Untersuchungsbereichs optimiert, der vorwiegend wassergebundene Protonen umfasst.

Der Pulssequenzabschnitt 6 aus Figur 3a umfasst als ersten gezeigten Puls 7 einen IR (Inversion Recovery) Puls. Der IR Puls 7 ist zur verbesserten Erfassung von Magnetresonanz-Messdaten von Fett vorgesehen. Der zweite Puls 8 des Pulssequenzabschnitts 6 aus Figur 3a bildet einen Fat-sat Puls, der auf die Resonanzfrequenz von Fett optimiert ist. Der kurz darauffolgende Puls 9 bildet einen Excitation (Anregung) Puls. Der Excitation Puls ist beispielsweise auf die Anregung von Fett und/oder Wasser optimiert.

Der Pulssequenzabschnitt 6 aus Figur 3 umfasst als ersten gezeigten Puls 10 einen MT (Magnetisation Transfer) Puls. Der MT Puls 10 ist zur Magnetisierungstransfer-Bildgebung (MTI) ausgebildet. Der MT Puls 10 ist zur Aufnahme von Magnetresonanz-Messdaten eines wasserdominierten Bereichs ausgebildet. Der zweite Puls 11 des Pulssequenzabschnitts 6 aus Figur 3b bildet einen Excitation (Anregung) Puls. Auf den Puls 11 folgen zwei Refokussierungspulse 12, 13, wobei die Refokussierungspulse 12, 13 zur Aufnahme von wassergebundenen Protonen optimiert bzw. ausgerichtet sind. Als Puls 14 umfasst der Pulssequenzabschnitt 6 einen Auslesepuls für Wasser. Die Pulssequenzabschnitte 6a, b können beide von der Mess-Pulssequenz umfasst sein und beispielsweise zeitlich versetzt in der Mess-Pulssequenz vorhanden sein, sodass die Mess-Pulssequenz sowohl separat fett- bzw. wasseroptimierte Teile umfasst.

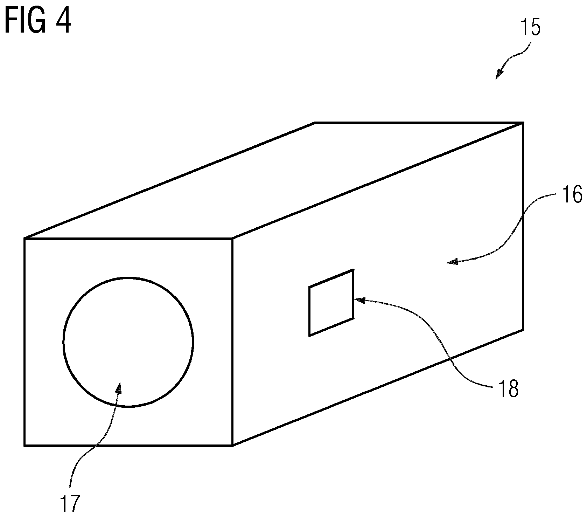

Fig. 4 zeigt schließlich eine Prinzipskizze eines erfindungsgemäßen Magnetresonanzgeräts 15, das eine Hauptmagneteinheit 16 mit dem das Grundmagnetfeld BO erzeugenden Magneten aufweist. Die Hauptmagneteinheit 16 definiert eine Patientenaufnahme 17, die umgebend (hier nicht näher dargestellt) die Gradientenspulenanordnung und die Hochfrequenzspulenanordnung vorgesehen sind, wie dies grundsätzlich bekannt ist.

Gesteuert werden die Komponenten des Magnetresonanzgeräts 15 über eine Steuereinheit 18, auch Rechnereinheit genannt, die zur Durchführung des erfindungsgemäßen Verfahrens ausgebildet ist. Insbesondere kann auf der Steuereinheit 18 ein erfindungsgemäßes Computerprogramm ablaufen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Aufnahme von Magnetresonanz-Messdaten eines Untersuchungsobjekts in einem Untersuchungsbereich mittels eines Magnetresonanzgeräts (15), umfassend die folgenden Verfahrensschritte:
- Messen (S1) einer BO-Feldkarte (1) des Untersuchungsbereichs basierend auf der Anwendung einer Pre-Pulssequenz,
- Bereitstellen (S2) einer Fett-Maske für den Untersuchungsbereich,
- Ermitteln (S3) einer Fett-BO-Feldkarte und einer Wasser-BO-Feldkarte basierend auf der gemessenen BO-Feldkarte (1) und der Fett-Maske,
- Ermitteln (S4) von mehreren Konfigurationsparametersätzen für das Magnetresonanzgerät (15), wobei ein Fett-Konfigurationsparametersatz basierend auf der Fett-BO-Feldkarte und ein Wasser-Konfigurationsparametersatz basierend auf der Wasser-BO-Feldkarte ermittelt werden, wobei der Fett-Konfigurationsparametersatz einen für Fett optimierten Konfigurationsparametersatz bildet und der Wasser-Konfigurationsparametersatz einen für Wasser optimierten Konfigurationsparametersatz bildet,
- Erstellen (S5) einer Mess-Pulssequenz basierend auf Fett-Konfigurationsparametersatz und dem Wasser-Konfigurationsparametersatz,
- Erfassen (S6) von Magnetresonanz-Messdaten des Untersuchungsbereichs des Untersuchungsobjekts basierend auf der Anwendung der Mess-Pulssequenz.

2. Verfahren nach Anspruch 1, **dadurch gekennzeichnet, dass** die Mess-Pulssequenz eine Mehrzahl an Pulssequenzabschnitten (6) umfasst, wobei in dem Verfahrensschritt (S5) Erstellen der Mess-Pulssequenz ein Pulssequenzabschnitt (6) basierend auf dem Fett-Konfigurationsparametersatz und ein weiterer Pulssequenzabschnitt basierend auf dem Wasser-Konfigurationsparametersatz ermittelt wird.

3. Verfahren nach Anspruch 2, **dadurch gekennzeichnet, dass** das Ermitteln des Wasser-Konfigurationsparametersatzes unabhängig vom Ermitteln des Fett-Konfigurationsparametersatzes erfolgt, wobei der auf dem Fett-Konfigurationsparametersatz basierende Pulssequenzabschnitt (6) der Messpulssequenz unabhängig von dem Wasser-Konfigurationsparametersatz ermittelt wird und/oder der auf dem Wasser-Konfigurationsparametersatz basierende weitere Pulssequenzabschnitt (6) der Messpulssequenz unabhängig von dem Fett-Konfigurationsparametersatz ermittelt wird.

4. Verfahren nach einem der vorherigen Ansprüche, **dadurch gekennzeichnet, dass** bei der Messung (S1) der BO-Feldkarte (1) und der Anwendung der Pre-Pulssequenz eine Resonanzfrequenz von in Fett gebundenen Protonen ortsaufgelöst ermittelt wird, wobei die Fett-Maske basierend auf der gemessenen ortsaufgelösten Resonanzfrequenz der Protonen ermittelt wird.

5. Verfahren nach einem der vorherigen Ansprüche, **dadurch gekennzeichnet, dass** die BO-Feldkarte (1) und die Fett-Maske basierend auf einem Multi-Echo-Verfahren ermittelt wird, wobei das Multi-Echo-Verfahren auf einer Messdatenaufnahme bei unterschiedlichen Dephasierungszeiten basiert.

6. Verfahren nach Anspruch 5, **dadurch gekennzeichnet, dass** basierend auf der Messdatenaufnahme eine Frequenzkarte umfassend eine Mehrzahl an Bildpunkten ermittelt wird, wobei die Bildpunkte der Frequenzkarte jeweils eine Abweichung von einer Nenn-Larmorfrequenz beschreiben, wobei die Fett-Maske basierend auf der Frequenzkarte und einem Glattheitskriterium ermittelt wird, wobei das Glattheitskriterium ein Kriterium für Sprünge in der Abweichung der Nenn-Larmorfrequenz zwischen Bildpunkten beschreibt.

7. Verfahren nach einem der vorherigen Ansprüche, **dadurch gekennzeichnet, dass** eine Bl-Feldkarte ermittelt wird, wobei der Fett-Konfigurationsparametersatz und der Wasser-Konfigurationsparametersatz basierend auf der Bl-Feldkarte ermittelt werden.

8. Verfahren nach Anspruch 7, **dadurch gekennzeichnet, dass** basierend auf der Bl-Feldkarte und der Fett-Maske eine Fett-Bl-Feldkarte und eine Wasser-Bl-Feldkarte bestimmt wird, wobei der Fett-Konfigurationsparametersatz basierend auf der Fett-Bl-Feldkarte und der Wasser-Konfigurationsparametersatz basierend auf der Wasser-Bl-Feldkarte ermittelt werden.

9. Verfahren nach einem der vorherigen Ansprüche, **dadurch gekennzeichnet, dass** der Fett-Konfigurationsparametersatz eine für Fett optimierte Protonen-Resonanzfrequenz umfasst.

10. Verfahren nach einem der vorherigen Ansprüche, **dadurch gekennzeichnet, dass** der Fett-Konfigurationsparametersatz ein für Fett optimiertes BO-Shimming erster Ordnung umfasst.

11. Verfahren nach einem der vorherigen Ansprüche, **dadurch gekennzeichnet, dass** der Fett-Konfigurationsparametersatz ein für Fett optimiertes Bl-Shimming umfasst.

12. Verfahren nach einem der vorherigen Ansprüche, **dadurch gekennzeichnet, dass** die Konfigurationsdatensätze und/oder die Mess-Pulssequenz schichtabhängig ermittelt werden.

13. Magnetresonanzgerät (15), umfassend:
- Eine Messeinheit, wobei die Messeinheit ausgebildet ist, eine BO-Feldkarte (1) des Untersuchungsbereichs basierend auf der Anwendung einer Pre-Pulssequenz zu messen und/oder zu ermitteln,
- Eine Maskenbereitstellungseinheit, wobei die Maskenbereitstellungseinheit ausgebildet ist, eine Fett-Maske für den Untersuchungsbereich bereitzustellen,
- Eine Maskierungseinheit, wobei die Maskierungseinheit ausgebildet ist, eine Fett-BO-Feldkarte und eine Wasser-BO-Feldkarte basierend auf der gemessenen BO-Feldkarte (1) und der Fett-Maske zu ermitteln,
- Eine Konfigurationsparameterbestimmungseinheit zur Ermittlung mehrerer Konfigurationsparametersätze für das Magnetresonanzgerät (15), wobei die Konfigurationsparameterbestimmungseinheit ausgebildet ist, einen Fett-Konfigurationsparametersatz basierend auf der Fett-BO-Feldkarte und einen Wasser-Konfigurationsparametersatz basierend auf der Wasser-BO-Feldkarte zu ermitteln, wobei der Fett-Konfigurationsparametersatz einen für Fett optimierten Konfigurationsparametersatz bildet und der Wasser-Konfigurationsparametersatz einen für Wasser optimierten Konfigurationsparametersatz bildet,
- Eine Pulssequenzerstellungseinheit, wobei die Pulssequenzerstellungseinheit ausgebildet ist, eine Mess-Pulssequenz basierend auf dem Fett-Konfigurationsparametersatz und dem Wasser-Konfigurationsparametersatz zu erstellen und/oder zu bestimmen,
- Eine Messdatenerfassungseinheit, wobei die Messdatenerfassungseinheit ausgebildet ist, Magnetresonanz-Messdaten des Untersuchungsbereichs des Untersuchungsobjekts basierend auf der Anwendung der Mess-Pulssequenz zu erfassen.

14. Computerprogramm umfassend Programmcode-Mittel, wobei das Computerprogramm ausgebildet ist, das Verfahren nach einem der Ansprüche 1 bis 12 auszuführen, wenn das Computerprogramm in der Steuereinheit (18) des Magnetresonanzgeräts (15) ausgeführt wird.

15. Speichermedium, wobei das Computerprogramm nach Anspruch 14 auf dem Speichermedium gespeichert ist.
